# EUROPÄISCHE PATENTSCHRIFT

(11) **EP 1 671 142 B1**
(45) Veröffentlichungstag und Bekanntmachung des Hinweises auf die Patenterteilung: **07.05.2008**
(21) Anmeldenummer: 04766662.3
(22) Anmeldetag: 01.09.2004
(51) Int. Cl.: G01R 31/36

(54) **VORRICHTUNG UND VERFAHREN ZUM MESSEN EINZELNER ZELLENSPANNUNGEN IN EINEM ZELLENSTAPEL EINES ENERGIESPEICHERS**
DEVICE AND METHOD FOR MEASURING INDIVIDUAL CELL VOLTAGES IN A CELL STACK OF AN ENERGY ACCUMULATOR
DISPOSITIF ET PROCEDE POUR MESURER DES TENSIONS DE CELLULE INDIVIDUELLES DANS UN EMPILEMENT DE CELLULES D'UN ACCUMULATEUR D'ENERGIE

(30) Priorität: 10.10.2003 DE 10347110
(43) Veröffentlichungstag der Anmeldung: 21.06.2006
(73) Patentinhaber: SIEMENS AKTIENGESELLSCHAFT, 80333 München (DE)
(72) Erfinder: BOLZ, Stephan, 93102 Pfatter (DE)
(86) Internationale Anmeldenummer: PCT/EP2004/051981
(87) Internationale Veröffentlichungsnummer: WO 2005/036191

(56) Entgegenhaltungen:
- EP-A- 0 432 639
- EP-A- 0 657 745
- PATENT ABSTRACTS OF JAPAN Bd. 1999, Nr. 02, 26. Februar 1999 (1999-02-26) -& JP 10 312829 A (NIPPON SOKEN INC; TOYOTA MOTOR CORP), 24. November 1998 (1998-11-24)
- PATENT ABSTRACTS OF JAPAN Bd. 1998, Nr. 01, 30. Januar 1998 (1998-01-30) -& JP 09 236624 A (MATSUSHITA ELECTRIC IND CO LTD), 9. September 1997 (1997-09-09)
- WANG X ET AL: "An Op Amp transfer circuit to measure voltages in battery strings" JOURNAL OF POWER SOURCES, ELSEVIER SEQUOIA S.A. LAUSANNE, CH, Bd. 109, Nr. 2, 1. Juli 2002 (2002-07-01), Seiten 253-261, XP004361535 ISSN: 0378-7753

## Beschreibung

Die Erfindung betrifft eine Vorrichtung zum Messen einzelner Zellenspannungen in einem Zellenstapel eines Energiespeichers, insbesondere eines Energiespeichers in einem Kraftfahrzeug-Bordnetz.

Die Erfindung betrifft auch ein Verfahren zum Betreiben dieser Vorrichtung.

In künftigen Kraftfahrzeug-Bordnetzen kommen neben heute üblichen Blei-Säure-Akkumulatoren auch andere, ebenfalls aus Einzelzellen aufgebaute Energiespeicher zum Einsatz, beispielsweise Nickel-Metall-Hydrid-Speicher, Lithium-Ionen-Speicher und Doppelschichtkondensatoren.

Bei Blei-Säure-Akkumulatoren erfolgt ein Ladungsausgleich zwischen den Einzelzellen des Akkumulators durch mäßiges Überladen des Akkumulators solange, bis schließlich alle Zellen geladen sind.

Aus EP 0 432 639 A2 ist bekannt, bei einer Vielzahl von in Reihe geschalteten Akkumulatoren einen Ladungsausgleich zwischen einem schwach geladenen Akkumulator und der Gruppe der übrigen Akkumulatoren mittels eines Rechteckgenerators, welcher über einen Transformator mit diesen Akkumulatoren verbunden ist, herbeizuführen.

Bei den genannten, neuartigen Energiespeichern ist jedoch die Empfindlichkeit der einzelnen Zellen gegen Überladung bzw. Überspannung ein Problem. Im Gegensatz zu Blei-Säure-Akkumulatoren darf beispielsweise bei einem Lithium-Ionen-Speicher die Ladespannung einer Zelle einen Wert von etwa 4.2V nicht wesentlich übersteigen, da sonst die Gefahr einer Zerstörung oder sogar Entflammung besteht. Bei Doppelschichtkondensatoren beträgt die maximale Ladespannung etwa 2.5 bis 2.7V.

Infolge fertigungsbedingter, unterschiedlicher Streuung der Selbstentladung der Zellen werden in einem Zellenstapel die Ladezustände und Zellenspannungen bei längerem Betrieb unterschiedliche Werte annehmen.

Ein Problem dabei ist, dass in der Regel nur die Gesamtspannung des Zellenstapels, also des Energiespeichers, als Polspannung erfasst werden kann, nicht aber die Spannung jeder einzelnen Zelle. Es kann also nur "auf Verdacht" periodisch ein Ladungsausgleich durchgeführt werden. Tritt jedoch eine erhöhte Selbstentladung - etwa gegen Lebensende des Energiespeichers - oder ein Fehler in einer Einzelzelle auf, beispielsweise ein Kurzschluss, so kann dieser nicht unmittelbar erfasst werden. Dies kann zur Folge haben, dass sich beim nächsten Ladevorgang die Ladespannung auf weniger Zellen verteilt, so dass Einzelzellen mit einer überhöhten Spannung belastet werden. Dies führt dann zur Zerstörung weiterer Zellen und muss in jedem Fall vermieden werden.

Es ist deshalb sehr wünschenswert, die Spannungen der einzelnen Zellen in einem Zellenstapel eines solchen Energiespeichers zu kennen, um entsprechend reagieren zu können.

Aus EP 0 657 745, JP 09 236 624 und JP 10 312 829 sind jeweils Vorrichtungen zum Messen einzelner Zellenspannungen in einem Zellenstapel bekannt.

Die Messung der einzelnen Zellenspannungen ist schwierig, weil nur die unterste Zelle Massebezug hat, also mit Bezug auf Masse (Bezugspotential) erfasst werden kann, während für alle anderen Zellen eine Umsetzung auf Massepotential erforderlich ist, um sie beispielsweise durch den Analog/Digital-Konverter eines Mikrocontrollers erfassen zu können.

Es ist Aufgabe der Erfindung, eine Vorrichtung zum Messen der Spannungen der einzelnen Zellen eines Zellenstapels eines Energiespeichers zu schaffen. Es ist auch Aufgabe der Erfindung, ein Verfahren zum Betreiben dieser Vorrichtung anzugeben.

Diese Aufgabe wird erfindungsgemäß durch eine Vorrichtung gemäß den Merkmalen des Anspruchs 1 und ein Verfahren gemäß den Merkmalen von Anspruch 3 gelöst.

Ausführungsbeispiele nach der Erfindung werden nachstehend anhand einer schematischen Zeichnung näher erläutert.

Vorteilhafte Weiterbildungen der Erfindung sind den Unteransprüchen zu entnehmen.

In der Zeichnung zeigen:
- Figur 1: ein Prinzipschaltbild einer Vorrichtung zur Messung der Zellenspannungen eines aus mehreren Zellen bestehenden Zellenstapels,
- Figur 2: ein Detailschaltbild einer ersten Vorrichtung zur Messung der Spannung einer Einzelzelle,
- Figur 3: Ein- und Ausgangssignale des in der ersten Schaltung verwendeten Differenzverstärkers Diff1,
- Figur 4: Ein- und Ausgangssignale des in der ersten Schaltung verwendeten Synchrongleichrichters Amp1,
- Figur 5: ein Detailschaltbild einer zweiten Vorrichtung mit einem alternativen Synchrongleichrichter Diff2,
- Figur 6: Ein- und Ausgangssignale des in der zweiten Schaltung verwendeten Differenzverstärkers Diff1,
- Figur 7: Ein- und Ausgangssignale des in der zweiten Schaltung verwendeten Synchrongleichrichters Diff2.

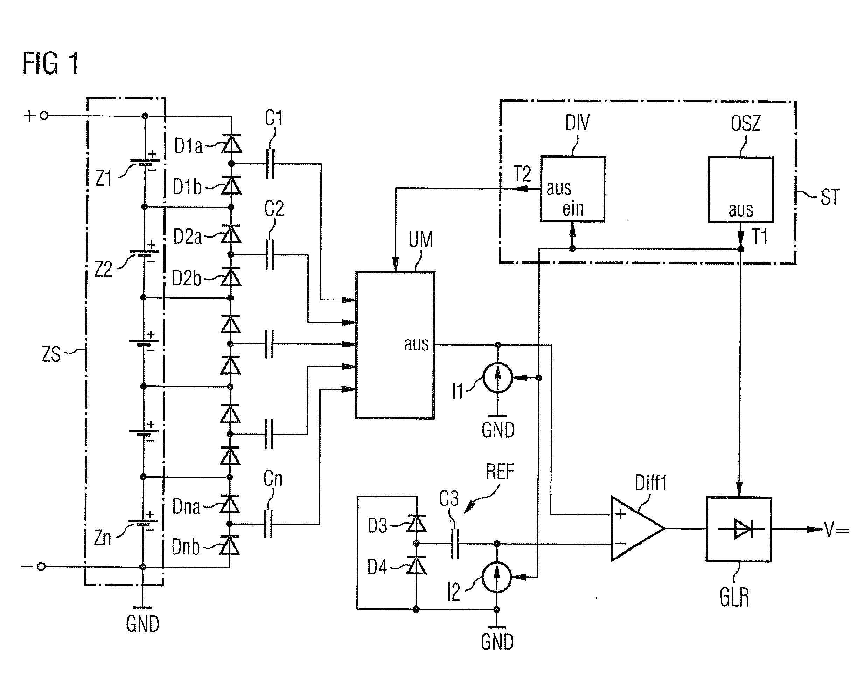

Figur 1 zeigt ein Prinzipschaltbild einer erfindungsgemäßen Vorrichtung zum Messen einzelner Zellenspannungen in einem Zellenstapel eines Energiespeichers. Dargestellt ist ein Zellenstapel ZS mit in Reihe geschalteten Zellen Z1, Z2 bis Zn beispielsweise eines Lithium-Ionen-Speichers, wobei die Anschlüsse der Zellen (Plus- und Minuspol) herausgeführt sind. Auf weitere Einzelheiten wird weiter unten näher eingegangen.

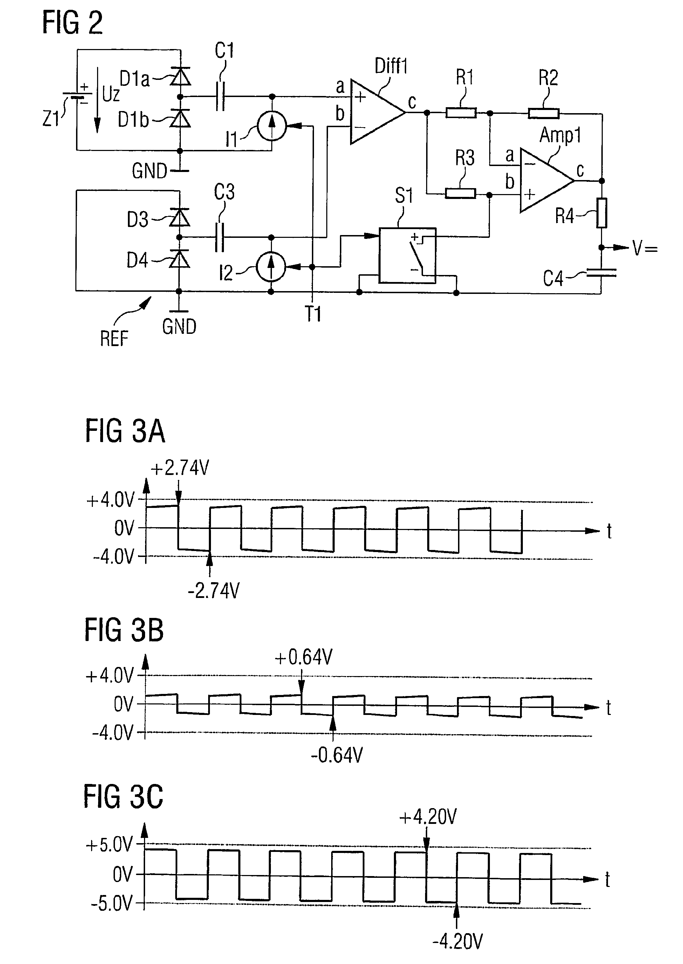

Die Erfindung wird zunächst anhand einer Vorrichtung zur Spannungsmessung an einer einzelnen Zelle gemäß eines in Figur 2 dargestellten Detailschaltbildes näher erläutert.

Figur 2 zeigt eine Vorrichtung zum Messen der Spannung einer Einzelzelle Z1 des in Figur 1 dargestellten Zellenstapels ZS, beispielsweise eines Lithium-Ionen-Speichers mit einer Zellenspannung Uz=4.2V, deren Minuspol mit Bezugspotential GND verbunden ist.

Parallel zu dieser Zelle Z1 ist eine Reihenschaltung zweier Dioden D1a und D1b angeordnet, die in Richtung vom Minuspol zum Pluspol der Zelle Z1 stromleitend sind.

Der Verbindungspunkt der beiden Dioden D1a und D1b ist über einen Kondensator C1 mit dem nichtinvertierenden Eingang a eines Differenzverstärkers Diff1 verbunden.

Eine Referenzschaltung REF weist zwei in Reihe geschaltete Dioden D3 und D4 auf, wobei die Anode der einen Diode - D4 - mit Bezugspotential GND und mit der Katode der anderen Diode - D3 - verbunden ist.

Der Verbindungspunkt der beiden Dioden D3 und D4 ist über einen Kondensator C3 mit dem invertierenden Eingang b des Differenzverstärkers Diff1 verbunden, dessen Ausgang c mit dem Eingang eines Gleichrichters führt, welcher in diesem Ausführungsbeispiel als Synchrondemodulator (Amp1,R1 bis R3 und S1) ausgeführt ist, auf den weiter unten näher eingegangen wird.

Das erfindungsgemäße Verfahren zum Betreiben dieser Vorrichtung arbeitet folgendermaßen:

Von einem Oszillatortakt T1 eines in Figur 2 nicht dargestellten Oszillators werden zwei Wechselstromquellen I1 und I2 gesteuert, wovon die erste Wechselstromquelle I1, zwischen nichtinvertierendem Eingang des Differenzverstärkers Diff1 bzw. dem Kondensator C1 und Bezugspotential GND angeordnet, einen Wechselstrom in den Kondensator C1 einspeist, während die zweite Wechselstromquelle I2, zwischen dem invertierendem Eingang des Differenzverstärkers Diff1 bzw. dem Kondensator C3 und Bezugspotential GND angeordnet, einen Wechselstrom in den Kondensator C3 der Referenzschaltung REF einspeist.

Die Wechselstromquelle I1 beaufschlagt den Kondensator C1 mit einem rechteckförmigen Wechselstrom von beispielsweise ±100µA. Die Taktfrequenz ist dabei so hoch zu wählen, dass sich der Kondensator während der Periodendauer nicht wesentlich auflädt oder entlädt.

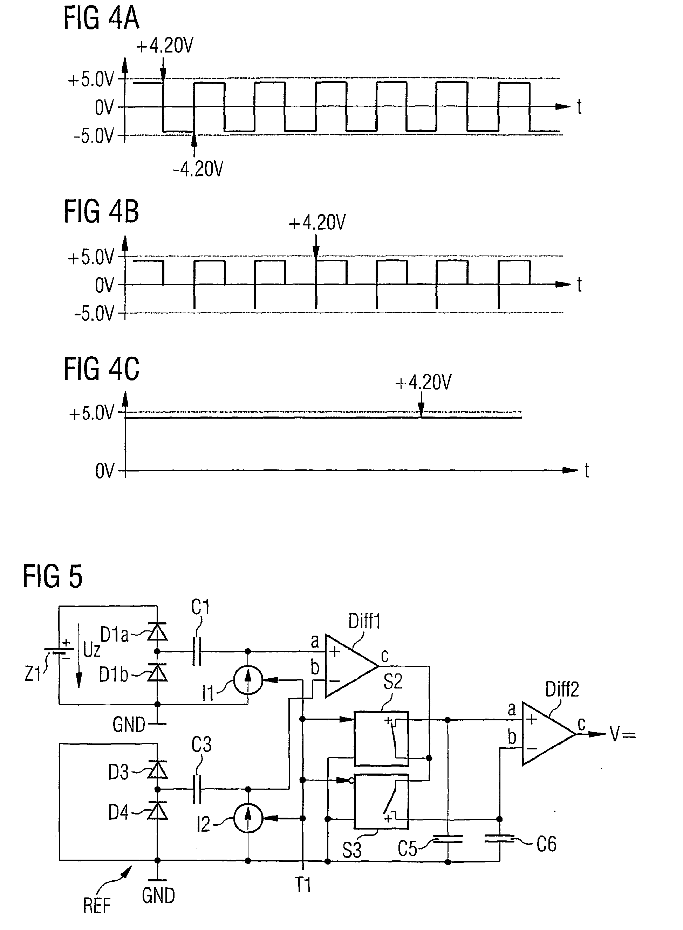

In den Figuren 3 und 4 sind die Ein- und Ausgangssignale des Differenzverstärkers Diff1 und des Operationsverstärkers Amp1 dargestellt, auf die im Verlauf der Beschreibung Bezug genommen wird.

Die Signale in den Figuren 3, 4, 6 und 7 sind jeweils in eingeschwungenem Zustand dargestellt.

Bei positivem Strom wird die Spannung an beiden Anschlüssen des Kondensators C1 so lange ansteigen, bis Diode D1a stromleitend wird; bei negativem Strom wird die Spannung an beiden Anschlüssen des Kondensators C1 so lange absinken, bis Diode D1b stromleitend wird.

Es entsteht somit eine rechteckförmige Wechselspannung, deren Spitze-Spitze-Wert im eingeschwungenen Zustand der Zellenspannung Uz, vermehrt um die Durchlassspannungen Ud der beiden Dioden D1a und D1b, entspricht: V1 = Uz + 2Ud = 4.2V + 2*0.64V = 5.48V = ±2.74V (siehe Figur 3a).

Die Wechselstromquelle I2 treibt mit gleicher Kapazität (C3 = C1) und Stromwert ±100µA den Kondensator C3 über die Durchlassspannungen der beiden Dioden D3 und D4. Da diese beiden Dioden mit Bezugspotential GND verbunden sind, beträgt die Wechselspannung hier V2 = 0V + 2*0.64V = 1.28V = ±0.64V (siehe Figur 3b). Dies ist die Wechselspannungsreferenz.

Im Differenzverstärker Diff1 wird nun die Differenz V1 - V2 gebildet: V1 - V2 = 5.48V - 1.28V = 4.2V. Da der Differenzverstärker in diesem Ausführungsbeispiel beispielsweise einen Verstärkungsfaktor von "2" hat, erscheint an seinem Ausgang c eine Wechselspannung von 8.4V = ±4.2V (siehe Figur 3c).

Die Ausgangsspannung des Differenzverstärkers Diff1 wird nun dem Synchrondemodulator Amp1 zugeführt. Dessen Eingangssignal am invertierenden Eingang entspricht dem Ausgangssignal des Differenzverstärkers Diff1 (Figur 4a = Figur 3c).

Der Synchrondemodulator besteht aus einem Operationsverstärker Amp1, Widerständen R1 bis R4 und einem Kondensator C4. Zwischen dem nichtinvertierenden Eingang des Operationsverstärkers Amp1 und Bezugspotential GND ist ein Schalter S1 angeordnet, welcher vom Oszillatortakt T1 umgeschaltet wird (Figur 4b).

Bei geöffnetem Schalter S1 (positive Amplitude des Rechtecksignals) hat der Operationsverstärker Amp1 einen Verstärkungsfaktor von "+1", bei geschlossenem Schalter S1 (negative Amplitude des Rechtecksignals) von "-1". In Figur 4b ist angedeutet, wie Schalter S1 den nichtinvertierenden Eingang des Operationsverstärkers Amp1 periodisch mit Bezugspotential verbindet und so den Verstärkungsfaktor umschaltet.

Das Ausgangssignal V= am Ausgang der Schaltung folgt dem Ausgangssignal des Operationsverstärkers Amp1, gefiltert mit einem aus Widerstand R4 und Kondensator C4 gebildeten Filter, wodurch etwaige Schaltstörungen eliminiert werden. Das Ausgangssignal V= entspricht der Spannung Uz der Zelle Z1 und ist am Ausgang des Synchrondemodulators, bezogen auf Bezugspotential GND (bzw. Massepotential, 0V) abgreifbar.

In Figur 5 ist ein weiteres Detailschaltbild, wie in Figur 2 gezeigt, jedoch mit einer alternativen Ausführung eines Synchrondemodulators, bestehend aus den Bauelementen Diff2, S2, S3, C5 und C6, dargestellt.

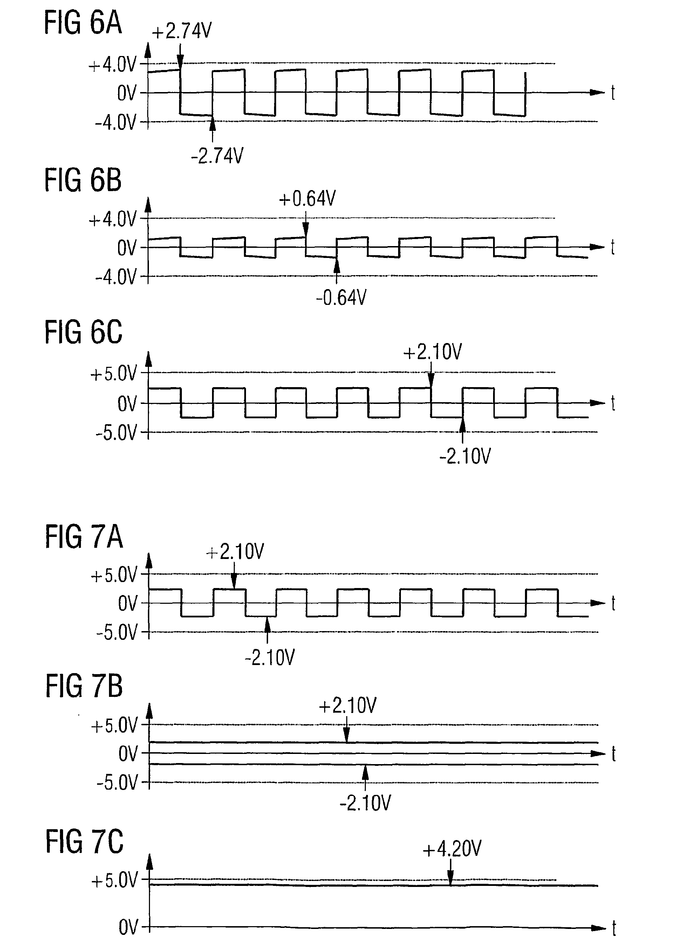

Die Schaltung von der Zelle Z1 über die Dioden D1a, D1b, D3, D4, die Kondensatoren C1 und C3 sowie die Wechselstromquellen I1 und I2 bis zum Ausgang c des Differenzverstärkers Diff1 entspricht der in Figur 2 dargestellten Schaltung. Auch die Eingangssignale an den Eingängen a (Figur 6a) und b (Figur 6b) entsprechen denen nach Figur 3a und 3b.

Das Ausgangssignal am Ausgang c des Differenzverstärkers Diff1 wird mittels zweier paralleler Schalter S2 und S3, mit dem Oszillatortakt T1 abwechselnd
- mit einem Kondensator C5 sowie dem nichtinvertierenden Eingang a eines weiteren Differenzverstärkers Diff2, bzw.
- mit einem Kondensator C6 sowie dem invertierenden Eingang b des weiteren Differenzverstärkers Diff2
verbunden.

Bei positiver Amplitude des Oszillatortakts T1 ist Schalter S2 geschlossen (leitend) und Schalter 3 geöffnet; bei negativer Amplitude des Oszillatortakts T1 ist Schalter S3 geschlossen und Schalter 2 geöffnet. Dadurch wird Kondensator C5 auf den positiven Wert (Figur 7b) und Kondensator C6 auf den negativen Wert (Figur 7b) des am Ausgang c des Differenzverstärkers Diff1 erscheinenden Wechselspannungs-Ausgangssignals (Figur 7a = Figur 6c) geladen.

Der weitere Differenzverstärker Diff2 bildet nun die Differenz der beiden an seinen Eingängen a und b anliegenden Gleichspannungen (im Beispiel Figur 7b: +2.10V und -2.10V = 4.20V: Figur 7c), die an seinem Ausgang c als massebezogene Gleichspannung V=, welche der Zellenspannung Uz entspricht, abgegriffen werden kann.

Ist in den Figuren 2 und 5 jeweils ein Detailschaltbild zum Messen einer einzigen Zellenspannung dargestellt, um das Verfahren besser erklären zu können, so zeigt Figur 1 ein Prinzipschaltbild einer erfindungsgemäßen Vorrichtung zum Messen einer Vielzahl von Zellenspannungen in einem Zellenstapel eines Energiespeichers.

Dargestellt ist ein Zellenstapel ZS mit in Reihe geschalteten Zellen Z1, Z2 bis Zn beispielsweise eines Lithium-Ionen-Speichers. Parallel zu jeder Zelle ist die Reihenschaltung zweier Dioden D1a-D1b bis Dna-Dnb angeordnet, die in Richtung vom Minuspol zum Pluspol der Zelle stromleitend sind.

Die Verbindungspunkte der beiden jeweils einer Zelle zugeordneten Dioden D1a-D1b bis Dna-Dnb sind über je einen Kondensator C1 bis Cn zu den Anschlüssen eines Umschalters UM geführt, der sie nacheinander, vom Teilersignal T2 einer Taktsteuerung ST gesteuert, mit seinem Ausgang verbindet.

Die Taktsteuerung ST besteht aus einem Oszillator OSZ, welcher ein Oszillatortaktsignal T1, eine rechteckige Wechselspannung einer bestimmten Frequenz, erzeugt, die mittels eines Frequenzteilers DIV zu einem Teilersignal T2 herabgesetzt wird, um den Umschalter UM nach erfolgter Erfassung der Zellenspannung weiterzuschalten.

Der Umschalter UM muss eine der Anzahl der Zellen des Zellenstapels entsprechende Zahl von Schaltstellungen aufweisen, die eine Größenordnung von 20 bis 30 (bei Doppelschichtkondensatoren) erreichen kann. Dieser Umschalter kann beispielsweise als CMOS-Schalter ausgeführt sein.

Vom Oszillatortakt T1 des Oszillators OSZ werden die aus Figur 2 bekannten beiden Wechselstromquellen I1 und I2 gesteuert, wovon die erste Wechselstromquelle I1 einen Wechselstrom über den Umschalter UM je nach dessen Schaltstellung in einen der Kondensatoren C1 oder C2 bis Cn einspeist, während die zweite Wechselstromquelle I2 einen Wechselstrom in den Kondensator C3 der Referenzschaltung REF einspeist, die neben diesem Kondensator C3 wieder zwei Dioden D3 und D4 aufweist, deren Verbindungspunkt mit dem Kondensator C3 verbunden ist.

Der Ausgang des Umschalters UM und der nicht mit den Dioden D3, D4 verbundene Anschluss des Kondensators C3 sind mit den Eingängen a und b des Differenzverstärkers Diff1 verbunden, dessen Ausgang c mit einem vom Oszillatortakt T1 gesteuerten Gleichrichter GLR verbunden ist, an dessen Ausgang nacheinander eine der jeweiligen Zellenspannung Uz proportionale Gleichspannung V= erscheint.

Der Gleichrichter GLR kann als ein in Figur 2 oder Figur 5 dargestellter Synchrondemodulator Amp1 oder Diff2 ausgebildet sein.

Das Ausgangssignal V= des Gleichrichters GLR entspricht im eingeschwungenen Zustand der Spannung Uz der jeweils mit dem Umschalter UM ausgewählten Zelle, nun aber potentialverschoben mit Bezug auf Masse GND.

Entsprechend wird mit jedem Weiterschalten des Umschalters UM die entsprechende Zellenspannung am Ausgang des Gleichrichters GLR dargestellt. Im Ergebnis werden so die einzelnen Zellenspannungen nacheinander massebezogen abgebildet.

Zur Überwachung der Zellenspannungen kann im einfachsten Falle die Spannungsfolge mit einem Grenzwertvergleicher gegen einen unteren und einen oberen Wert verglichen werden. Ein Überschreiten des Maximalwertes weist dabei auf eine Überspannung der Zelle hin; ein Unterschreiten des Minimalwertes auf einen Kurzschluss. Diese Information kann nun einer Überwachungseinheit zugeführt werden, die daraufhin geeignete Maßnahmen ergreift; etwa einen Abbruch des Ladevorganges, das Einleiten eines Ladeausgleichsvorganges, oder eine Information an den Fahrer, dass eine Werkstatt aufgesucht werden muss.

Die Überwachung mittels Grenzwertvergleicher ist allerdings recht grob. So ist beispielsweise die betroffene Zelle nicht identifizierbar. Auch ist bei einem Ladungsausgleichsvorgang das Erreichen des Ladungsgleichgewichtes nicht erkennbar.

Bei einer verfeinerten Überwachung mittels Microcontroller können die Spannungswerte V= nacheinander im zeitlichen Bezug zum Schalttakt des Umschalters erfasst werden, so dass eine weitere Bewertung der Zellenspannung mittels Überwachungssoftware erfolgen kann.

Beim Ladungsausgleich ist das langsame Angleichen der einzelnen Zellenspannungen erkennbar, so dass eine Beendigung des Lade- oder Umladevorganges bestimmt werden kann.

Auch ist eine Langzeitüberwachung der Einzelzellen möglich, so dass - etwa bei erkennbarem Abfall der Kapazität einer Zelle, einem Anstieg der Selbstentladung oder einem Anstieg des Innenwiderstandes einer Zelle - ein Warnhinweis abgegeben werden kann, dass ein Werkstattbesuch erforderlich ist.

Dies erhöht die Zuverlässigkeit des Systems ganz wesentlich und senkt die Reparaturkosten, da nun nur noch die defekte Zelle ersetzt werden muss und nicht mehr der ganze Zellenstapel.

## Patentansprüche

1. Vorrichtung zum Messen einzelner Zellenspannungen (Uz) der Zellen (Z1 bis Zn) in einem Zellenstapel (ZS) eines Energiespeichers, insbesondere eines Energiespeichers in einem Kraftfahrzeug-Bordnetz, in der
parallel zu jeder Zelle (Z1 bis Zn) eine Reihenschaltung zweier Dioden (D1a-D1b bis Dna-Dnb), die in Richtung vom Minuspol zum Pluspol der Zelle (Z1 bis Zn) stromleitend sind, angeordnet ist,
ein Umschalter vorgesehen ist, welcher eine der Anzahl der Zellen (Z) des Zellenstapels (ZS) entsprechende Zahl von einzelnen Schaltstellungen zugeordneten Anschlüssen aufweist, welche über je einen Kondensator (C1 bis Cn) mit den Verbindungspunkten der den Zellen zugeordneten Dioden (D1a-D1b bis Dna-Dnb) verbunden sind,
eine Referenzschaltung (REF) vorgesehen ist, welche zwei in Reihe geschaltete Dioden (D3, D4) aufweist, wobei die Anode der einen Diode (D4) mit Bezugspotential (GND) und mit der Katode der anderen Diode (D3) verbunden ist,
ein Differenzverstärker (Diff1) vorgesehen ist, dessen nichtinvertierender Eingang mit dem Ausgang des Umschalters (UM) verbunden ist, und dessen invertierender Eingang über einen Kondensator (C3) mit dem Verbindungspunkt der beiden Dioden (D3, D4) verbunden ist,
ein gesteuerter Gleichrichter (GLR) vorgesehen ist, dessen Eingang mit dem Ausgang des Differenzverstärkers (Diff1) verbunden ist, und an dessen Ausgang eine der Zellenspannung (Uz) der jeweils über den Umschalter (UM) ausgewählten Zelle proportionale, auf Bezugspotential (GND) bezogene Gleichspannung (V=) abgreifbar ist,
eine erste, gesteuerte Wechselstromquelle (11) vorgesehen ist, die zwischen dem nichtinvertierendem Eingang des Differenzverstärkers (Diff1) und Bezugspotential (GND) angeordnet ist,
eine zweite, gesteuerte Wechselstromquelle (I2) vorgesehen ist, die zwischen dem invertierendem Eingang des Differenzverstärkers (Diff1) und Bezugspotential (GND) angeordnet ist, und
eine Taktsteuerung (ST) vorgesehen ist, welche einen Oszillator (OSZ) aufweist, der ein Oszillatortaktsignal (T1) ausgibt, und einen Frequenzteiler (DIV) aufweist, welcher ein Teilersignal (T2) ausgibt,
wobei die beiden Wechselstromquellen (11, I2) und der Gleichrichter (GLR) mit dem Oszillatortakt (T1) gesteuert werden und der Umschalter (UM) mit dem Teilersignal (T2) gesteuert wird.

2. Vorrichtung nach Anspruch 1, **dadurch gekennzeichnet, dass** der Gleichrichter (GLR) als ein vom Oszillatortakt (T1) gesteuerter Synchrondemodulator (Amp1, Diff2) ausgebildet ist.

3. Verfahren zum Betreiben der Vorrichtung nach Anspruch 1,
wobei
zum Messen der Zellenspannung (Uz) einer bestimmten Zelle (Z1 bis Zn) des Zellenstapels (ZS) ein erster, rechteckförmiger Wechselstrom bestimmter Frequenz (T1) und Amplitude in den der Zelle zugeordneten Kondensator (C1 bis Cn) eingespeist wird, wodurch eine Wechselspannung (V1) entsteht, welche der Zellenspannung (Uz), vermehrt um die Durchlassspannungen (Ud) der beiden zur Zelle (Uz) parallel liegenden Dioden (D1a-D1b bis Dna-Dnb) entspricht,
ein dem ersten, rechteckförmigen Wechselstrom in Frequenz und Amplitude gleicher Wechselstrom in den der Referenzschaltung (REF) zugeordneten Kondensator (C3) eingespeist wird, wodurch eine auf Bezugspotential (GND) bezogene Wechselspannung (V2) entsteht, welche der Durchlassspannung (2*Du) der beiden der Referenzschaltung (REF) zugeordneten Dioden (D3, D4) entspricht,
die Differenz (V1-V2) der beiden Wechselspannungen (V1, V2) gebildet wird, wodurch eine der Zellenspannung (Uz) entsprechende Wechselspannung entsteht, und
die der Zellenspannung (Uz) entsprechende Wechselspannung gleichgerichtet wird, wodurch eine der Zellenspannung (Uz) entsprechende, auf Bezugspotential (GND) bezogene Gleichspannung (V=) entsteht.

4. Verfahren nach Anspruch 3, **dadurch gekennzeichnet, dass** dieses Verfahren nacheinander auf alle Zellen (Z1 bis Zn) des Zellenstapels (ZS) angewandt wird.

5. Verfahren nach Anspruch 3 oder 4, **dadurch gekennzeichnet, dass** die Frequenz (T1) der in die Kondensatoren (C1 bis Cn und C3) eingespeisten Wechselströme so hoch gewählt ist, dass sich die Kondensatoren während der Periodendauer nicht wesentlich auf- oder entladen.

6. Verfahren nach Anspruch 3 oder 4, **dadurch gekennzeichnet, dass** die Amplituden der in die Kondensatoren (C1 bis Cn und C3) eingespeisten Wechselströme im µA-Bereich liegen.

7. Verfahren nach Anspruch 3 oder 4, **dadurch gekennzeichnet, dass** die der Zellenspannung (Uz) jeder Zelle (Z1 bis Zn) entsprechende, auf Bezugspotential (GND) bezogene Gleichspannung (V=) einem Grenzwertvergleich mit einem oberen und einem unteren Grenzwert unterzogen wird, wobei ein Überschreiten des oberen Grenzwertes auf eine Überspannung der zelle, und ein Unterschreiten des unteren Grenzwertes auf einen Kurzschluss der Zelle hinweist.

8. Verfahren nach Anspruch 3 oder 4, **dadurch gekennzeichnet, dass** die den Zellenspannungen (Uz) jeder Zelle (Z1 bis Zn) entsprechenden, auf Bezugspotential (GND) bezogenen Gleichspannungswerte (V=) gespeichert werden, wodurch beim Ladungsausgleich das langsame Angleichen einzelner Zellenspannungen (Uz) erkennbar wird und eine Beendigung des Lade- oder Umladevorgangs bestimmbar ist, sowie eine Langzeitüberwachung jeder einzelnen Zelle (Z1 bis Zn) auf einen Abfall der Kapazität oder einen Anstieg der Selbstentladung oder des Innenwiderstandes erfolgen kann.

## Claims

1. Device to measure individual cell voltages (Uz) of the cells (Z1 to Zn) in a cell stack (ZS) of an energy accumulator, especially of an energy accumulator in a motor vehicle electrical system, in which a series circuit of two diodes (D1a-D1b to Dna-Dnb), which conduct current in the direction from the minus pole to the plus pole of the cell, is arranged in parallel to each cell (Z1 to Zn), a changeover switch is provided which features a number of terminals assigned to switch positions corresponding to the number of cells (Z) of the cell stack (ZS), which are connected via a capacitor (C1 to Cn) in each case to the connection points of the diodes (D1a-D1b to Dna-Dnb) assigned to the cells, a reference circuit (REF) is provided which features two series-connected diodes (D3, D4), with the anode of one diode (D4) being connected to reference potential (GND) and to the cathode of the other diode (D3), a differential amplifier (Diff1) is provided, of which the non-inverted input is connected to the output of the changeover switch (UM) and of which the inverted input is connected via a capacitor (C3) to the connection point of the two diodes (D3, D4), a controlled rectifier (GLR) is provided of which the input is connected to the output of the differential amplifier (Diff1) and at the output of which a direct current (V=) related to reference potential (GND) proportional to the cell voltage (Uz) of the cells selected in each case using the changeover switch (UM) can be tapped off, a first controlled alternating current source (I1) is provided is arranged between the non-inverting input of the differential amplifier (Diff1) and reference potential (GND), a second controlled alternating current source (I2) is provided which is arranged between the inverting input of the differential amplifier (Diff2) and reference potential (GND), a clock control (ST) is provided which features an oscillator (OSZ) which outputs an oscillator clock signal (T1) and features a frequency divider (DIV) which outputs a divider signal (T2), with the two alternating current sources (I1, I2) and the rectifier (GLR) being controlled by the oscillator clock (T1) and the changeover switch (UM) being controlled by the divider signal (T2).

2. Device in accordance with claim 1, **characterised in that** the rectifier (GLR) is embodied as a synchronous demodulator (Amp1, Diff2) controlled by the oscillator clock (T1).

3. Method for operating the device in accordance with claim 1, whereby, to measure the cell voltage (Uz) of a specific cell (Z1 to Zn) of the cell stack (ZS) a first, square-wave alternating current of a specific frequency (T1) and amplitude is injected into the capacitor (C1 to Cn) assigned to the cell, which produces an alternating voltage (V1) which corresponds to the cell voltage (Uz), multiplied by the on-state voltages (Ud) of the two diodes (D1a-D1b to Dna-Dnb) lying in parallel to the cell (Uz), an alternating current which is equal in frequency and amplitude to the first square-wave alternating current is injected into the capacitor (C3) assigned to the reference circuit (REF), which produces an alternating voltage (V2) related to reference potential (GND) which corresponds to the on-state current (2*Du) of the two diodes (D3, D4) assigned to the reference circuit (REF), the difference (V1-V2) between the two alternating voltages (V1, V2) is formed, with an alternating voltage corresponding to the cell voltage (Uz) arising, and, the alternating voltage corresponding to the cell voltage (Uz) is rectified which produces a direct voltage (V=) corresponding to the cell voltage (Uz) related to reference potential (GND).

4. Method in accordance with claim 3, **characterised in that** this method is applied consecutively to all cells (Z1 to Zn) of the cell stack (ZS).

5. Method in accordance with claim 3 or 4, **characterised in that** the frequency (T1) of the alternating currents injected into the capacitors (C1 to Cn and C3) is selected to be high enough so that the capacitors do not significantly charge or discharge during the oscillation period.

6. Method in accordance with claim 3 or 4, **characterised in that** the amplitudes of the alternating currents injected into the capacitors (C1 to Cn and C3) lie within the µA range.

7. Method in accordance with claim 3 or 4, **characterised in that** the direct current voltage (V=) corresponding to the cell current (Uz) of each cell (Z1 to Zn) related to reference potential (GND) is subjected to a limit value comparison at the upper and a lower limit value, in which case exceeding the upper limit value indicates an overvoltage of the cell and falling below the lower limit value indicates a short-circuit the cell.

8. Method in accordance with claim 3 or 4, **characterised in that** the direct current voltage values (V=) corresponding to the cell voltages (Uz) of each cell (Z1 to Zn) related to reference potential (GND) are stored, in which case during charge balancing, the slow balancing of individual cell voltages (Uz) can be detected and the termination of the charging or discharging process can be defined as well as a long-term supervision of each individual cell (Z1 to Zn) for a drop in the capacitance or an increase in the self-discharge or the internal resistance.

## Revendications

1. Dispositif pour mesurer des tensions de cellules (Uz) individuelles des cellules (Z1 à Zn) dans une pile de cellules (Zs) d'un accumulateur d'énergie, en particulier d'un accumulateur d'énergie dans un réseau de bord de véhicule, dans lequel
un circuit de série de deux diodes (D1a-D1b jusqu'à Dna-Dnb), qui sont conductrices du pôle négatif vers le pôle positif de la cellule (Z1 à Zn), est disposé parallèlement à chaque cellule (Z1 à Zn),
il est prévu un inverseur qui présente un nombre, correspondant au nombre des cellules (Z) de la pile de cellules (ZS), de branchements attribués à des positions de commutation individuelles, lesquels branchements sont reliés chacun par un condensateur (C1 à Cn) aux points de liaison des diodes (D1a-D1b jusqu'à Dna-Dnb) attribuées aux cellules,
il est prévu un circuit de référence (REF), qui présente deux diodes (D3, D4) montées en série, l'anode d'une diode (D4) étant reliée au potentiel de référence (GND) et à la cathode de l'autre diode (D3),
il est prévu un amplificateur différentiel (Diff1), dont l'entrée non inverseuse est reliée à la sortie de l'inverseur (UM), et dont l'entrée inverseuse est reliée par un condensateur (C3) au point de liaison des deux diodes (D3, D4),
il est prévu un redresseur (GLR) commandé, dont l'entrée est reliée à la sortie de l'amplificateur différentiel (Diff1), et à la sortie duquel une tension continue (V=) proportionnelle à la tension de cellule (Uz) de la cellule choisie respectivement par l'inverseur (UM) et rapportée au potentiel de référence (GND) peut être prélevée,
il est prévu une première source de courant alternatif (I1) commandée, qui est disposée entre l'entrée non inverseuse de l'amplificateur différentiel (Diff1) et le potentiel de référence (GND),
il est prévu une seconde source de courant alternatif (I2) commandée, qui est disposée entre l'entrée inverseuse de l'amplificateur différentiel (Diff1) et le potentiel de référence (GND), et
il est prévu une commande de cycle (ST) qui présente un oscillateur (OSZ) qui émet un signal de rythme d'oscillateur (T1) et un diviseur de fréquence (DIV) qui émet un signal diviseur (T2),
les deux sources de courant alternatif (I1, I2) et le redresseur (GLR) étant commandés avec le cycle d'oscillateur (T1) et l'inverseur (UM) étant commandé avec le signal diviseur (T2).

2. Dispositif selon la revendication 1, **caractérisé en ce que** le redresseur (GLR) est conçu comme un modulateur synchrone (Amp1, Diff2) commandé par le cycle d'oscillateur (T1).

3. Procédé pour l'exploitation du dispositif selon la revendication 1,
dans lequel, pour mesurer la tension de cellule (Uz) d'une cellule (Z1 à Zn) définie de la pile de cellules (ZS), on injecte un premier courant alternatif rectangulaire de fréquence (T1) définie et de l'amplitude dans le condensateur (C1 à Cn) attribué à la cellule, de sorte qu'une tension alternative (V1) se forme, qui correspond à la tension de cellule (Uz), augmentée des tensions de passage (Ud) des diodes (D1a-D1b jusqu'à Dna-Dnb) parallèles à la cellule (Uz),
un courant alternatif identique au premier courant alternatif rectangulaire en fréquence et en amplitude est injecté dans le condensateur (C3) attribué au circuit de référence (REF), une tension alternative (V2) spécifique au potentiel de référence (GND) se formant, laquelle correspond à la tension de passage (2*Du) des diodes (D3, D4) attribuées au circuit de référence (REF),
la différence (V1-V2) des deux tensions alternatives (V1, V2) étant formée, de sorte qu'une tension alternative correspondant à la tension de cellule (Uz) se forme, et
la tension alternative correspondant à la tension de cellule (Uz) étant redressée, de sorte qu'une tension continue (V=) correspondant à la tension de cellule (Uz) et rapportée au potentiel de référence (GND) se forme.

4. Procédé selon la revendication 3, **caractérisé en que** ce procédé est appliqué successivement à toutes les cellules (Z1 à Zn) de la pile de cellules (ZS).

5. Procédé selon la revendication 3 ou 4, **caractérisé en ce que** la fréquence (T1) des courants alternatifs injectés dans les condensateurs (C1 à Cn et C3) est choisie suffisamment élevée pour que les condensateurs ne se chargent pas ou ne se déchargent pas de façon importante pendant la durée de période.

6. Procédé selon la revendication 3 ou 4, **caractérisé en ce que** les amplitudes des courants alternatifs injectés dans les condensateurs (C1 à Cn et C3) sont sous de l'ordre du µA.

7. Procédé selon la revendication 3 ou 4, **caractérisé en ce que** la tension continue (V=) correspondant à la tension de cellule (Uz) de chaque cellule (Z1 à Zn) et rapportée au potentiel de référence (GND) est soumise à une comparaison de valeur limite avec une valeur limite supérieure et une valeur limite d'inférieure, un dépassement de la valeur limite supérieure indiquant une surtension de la cellule et un sous dépassement de la valeur limite inférieure un court-circuit de la cellule.

8. Procédé selon la revendication 3 ou 4, **caractérisé en ce que** les valeurs de tension continue (V=) correspondant aux tensions de cellules (Uz) de chaque cellule (Z1 à Zn) et rapportées au potentiel de référence (GND) sont stockées, l'alignement lent de tensions de cellules (Uz) individuelles devenant identifiable lors de l'équilibrage de charge et un achèvement de l'opération de chargement ou d'inversion de charge pouvant être déterminé, et un contrôle de longue durée de chaque cellule (Z1 à Zn) individuelle entraînant une chute de la capacité ou une augmentation de l'autodécharge ou de la résistance intérieure pouvant s'effectuer.
